# EUROPEAN PATENT SPECIFICATION

(11) **EP 1 024 403 B1**
(45) Date of publication and mention of the grant of the patent: **10.09.2003**
(21) Application number: 00101628.6
(22) Date of filing: 28.01.2000
(51) Int. Cl.: G03D 13/00, B65G 39/04, G03F 7/26

(54) **Heating apparatus**
Heizgerät
Appareil de chauffage

(30) Priority: 28.01.1999 JP 2022399
(43) Date of publication of application: 02.08.2000
(73) Proprietor: FUJI PHOTO FILM CO., LTD., Kanagawa 250-01 (JP)
(72) Inventor: Sasayama, Hiroyuki, Yoshida-cho, Haibara-gun, Shizuoka (JP); Oishi, Chikashi, Yoshida-cho, Haibara-gun, Shizuoka (JP)
(74) Representative: HOFFMANN - EITLE

(56) References cited:
- DE-A- 2 144 488
- DE-B- 1 137 677
- US-A- 4 544 253
- US-A- 5 583 600
- PATENT ABSTRACTS OF JAPAN vol. 1999, no. 04, 30 April 1999 (1999-04-30) & JP 11 015168 A (FUJI PHOTO FILM CO LTD), 22 January 1999 (1999-01-22)

## Description

### BACKGROUND OF THE INVENTION

### 1. Field of the Invention

The present invention relates to a heating apparatus for heating a photosensitive planographic printing plate having a metal support member on which a photosensitive layer is formed while conveying the photosensitive planographic printing plate which has been exposed to light.

### 2. Description of the Related Art

Photosensitive materials suitable to manufacture printing plates have been disclosed in European Patent No. 0298522, European Patent No. 0426192, U.S. Patent No. 5290659, and Unexamined Japanese Patent Publication Nos. 5-142775, 6-27652 and 5-107764. The foregoing photosensitive materials are characterized by using a hardening reaction in which silver halide serves as an optical sensor. The photosensitive material has a support member on which a hardening layer containing at least a polymerizable compound or crosslinking polymers, a photosensitive layer containing silver halide and an overcoat layer containing base precursor are sequentially laminated. Any one of the foregoing layers contains a reducing agent (hereinafter the foregoing photosensitive material is called a "silver trigger polymerizing photosensitive material"). A method of manufacturing the printing plate is executed such that the foregoing heat development is performed to harden the polymerizing compounds or the crosslinking polymers. Then, an eluent is used to remove non-hardened portions so that the residual images which have been hardened are used as the images of the printing plate.

Note that the printing plate incorporates a metal plate (usually made of aluminum) which serves as a support member.

Materials for planographic printing plates disclosed in unexamined Japanese Patent Publication No. 7-20625 and Japanese Patent Application No. 10-22404 have sensitivity with respect to infrared wavelengths. After the material has been exposed to light, the material is subjected to heat treatment, if necessary. Then, the material is developed with alkali solution so that non-hardened portions are removed. Thus, residual images which have been hardened are used as images of the printing plate.

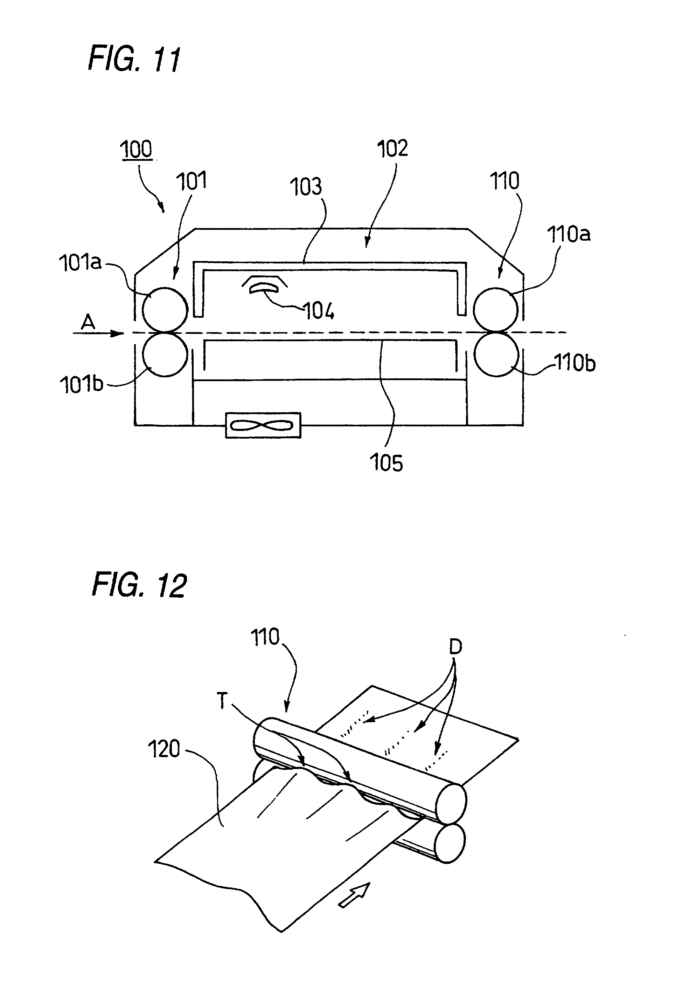

Conventionally, a heating apparatus for heating a printing plate as shown in Fig. 11 has been employed. A heating apparatus 100 is provided with an introducing roller unit 101 constituted by a pair of rollers 101a and 101b for holding, form upper and lower positions, a printing plate inserted from a direction indicated with an arrow A so that the printing plate is introduced into the heating apparatus. The introduced printing plate is conveyed to a heating portion 102 formed in the heating apparatus. The heating portion 102 incorporates a heat insulating case 103 in which a heater 104 and a guide plate 105 for guiding the printing plate are disposed in such a manner that heat emitted from the heater 104 is radiated to the printing plate. The printing plate heated by the heating portion 102 is discharged to the outside of the heating apparatus by a discharge roller unit 110 composed of a pair of rollers 110a and 110b which hold the printing plate from upper and lower positions. Thus, the printing plate is conveyed to a next process.

The conventional heating apparatus 100 has the pairs of rollers which constitute the introducing roller unit 101 and the discharge roller unit 110, which are cylindrical rollers. In the heating apparatus 100, the printing plate introduced by the introducing roller unit is heated by the heating portion. Thus, the printing plate is expanded in the lengthwise and widthwise directions thereof. At this time, the upstream and downstream portions of the printing plate are held by the introducing roller unit 101 and the discharge roller unit 110 each of which is composed of a pair of cylindrical rollers. Therefore, expansion sometimes causes a portion of the printing plate 120 to be protruded over the guide plate, that is, to be deformed to rise over the guide plate, as shown in Fig. 12. Deformed portions T of the printing plate 120 formed over the guide plate cause lines and stripe patterns D to be formed on the surface of the printing plate 120 when the upper and lower surfaces of the deformed portions T are held and crushed by the discharge roller unit 110. If things come to the worst, stepped portions are formed on the surface of the printing plate.

Also in a case where comb rollers are employed as the pairs of rollers which constitute the introducing roller unit and the discharge roller unit, lines or the like are undesirably formed on the surface of the printing plate.

### SUMMARY OF THE INVENTION

It is an object of the present invention to provide a heating apparatus which is capable of heating a printing plate such that formation of a line or the like on the surface of the printing plate can be prevented.

The foregoing object of the present invention can be achieved by a heating apparatus according to any one of the appended claims.

According to the structure disclosed in claims 1 and 5, the disc-like members of the downstream conveying rollers rotate integrally with the drive shaft in a usual state. If stress is produced in the printing plate when the printing plate expands in the lengthwise direction, the stress causes the disc-like members to be rotated relative to the drive shaft. As a result, deformation of a portion of the printing plate to rise over the guide member due to the expansion of the printing plate in the lengthwise direction can be prevented. Thus, formation of a line or the like on the surface of the printing plate can be prevented.

According to the structure disclosed in claim 2, when the portion of the printing plate deformed to rise over the guide member due to expansion of the printing plate in the widthwise direction has been conveyed to a space between the pair of rollers, the disc-like members are deformed in the direction of the thickness of the disc-like members to correspond to the shape of the deformed portion of the printing plate. Therefore, formation of a line or the like on the surface of the printing plate can furthermore satisfactorily be prevented.

According to the structure disclosed in claim 3, the disc-like members of the downstream conveying rollers rotate integrally with the drive shaft in a usual state. When the portion of the printing plate, deformed to rise over the guide member due to expansion of the printing plate, has been conveyed to a space between the pair of rollers, the disc-like members are moved in the axial direction of the drive shaft with respect to the drive shaft. As a result, formation of a line or the like on the surface of the printing plate can be prevented.

According to the structure disclosed in claim 4, when the portion of the printing plate deformed to rise over the guide member due to expansion of the printing plate has been conveyed to a space between the pair of the rollers of the downstream conveying rollers, the disc-like members are deformed in the direction of the thickness of the disc-like members to correspond to the shape of the deformed portion of the printing plate. As a result, formation of a line or the like on the surface of the printing plate can be prevented.

The disc-like member may be made of rubber or resin. It is preferable that rubber is employed. The disc-like member may be constituted by stacking a plurality of thin platelike members. A structure may be employed in which each of both of the pair of the rollers which constitute the downstream conveying rollers incorporates at least a drive shaft and a disc-like member. The upstream conveying rollers may have the above-mentioned structure.

The photosensitive material which is the subject of the present invention is not limited particularly if the photosensitive material is developed with heat or a photosensitive material must be heated before wet development. Also the following silver trigger polymerizing photosensitive materials may be processed as preferred photosensitive materials, the materials being disclosed in European Patent No. 0298522, European Patent No. 0426192, U.S. Patent No. 5290659, and Unexamined Japanese Patent Publication Nos. 5-142775, 6-27652 and 5-107764.

Unexamined Japanese Patent Publication No. 7-20625 and Japanese Patent Application No. 10-22404 as described above, a negative-type image recording material has been disclosed which is characterized by containing the following materials (A) to (D):
(A) A compound which is decomposed with light or heat to generate acid.
(B) A crosslinking agent which crosslinks due to acid.
(C) At least one type of alkali-soluble resin.
(D) An infrared-ray absorbing agent.

The image of the material for planographic printing incorporating the foregoing negative-type image recording material is exposed by a solid-state laser or a semiconductor laser which emits infrared rays having a wavelength of 760 nm to 1200 nm. After irradiation by the laser has been completed, a wet developing process may immediately be performed. It is preferable that the foregoing process is performed between the laser irradiation process and the developing process. It is preferable that heating is performed at 80°C to 150°C for 10 seconds to 5 minutes. Also the present invention is effective for the foregoing heating process.

As a result of the foregoing heating process, energy of the laser required to perform recording can be reduced. The foregoing material is subjected to a heating process, if necessary. Then, the material is developed with alkali solution so that non-hardened portions are removed and residual images which have been hardened are used as the images of the printing plate.

### BRIEF DESCRIPTION OF THE DRAWINGS

In the accompanying drawings:
Fig. 1 is a diagram showing a first embodiment of the present invention;
Fig. 2 is a cross sectional view taken along line Y-Y shown in Fig. 1;
Fig. 3 is a diagram showing a roller according to the second embodiment;
Fig. 4 is a cross sectional view taken along line Y-Y shown in Fig. 3;
Fig. 5 is a diagram showing a roller according to a third embodiment;
Fig. 6 is a diagram showing a roller according to a fourth embodiment;
Fig. 7 is a diagram showing a roller according to a fifth embodiment;
Fig. 8 is a diagram showing a roller according to a sixth embodiment;
Fig. 9 is a diagram showing a roller according to a seventh embodiment;
Fig. 10 is a schematic cross sectional view showing a plate making apparatus to which the present invention is applied;
Fig. 11 is a diagram showing a conventional heating apparatus; and
Fig. 12 is a diagram showing a state in which a printing plate is deformed due to heat.

### PREFERRED EMBODIMENTS OF THE INVENTION

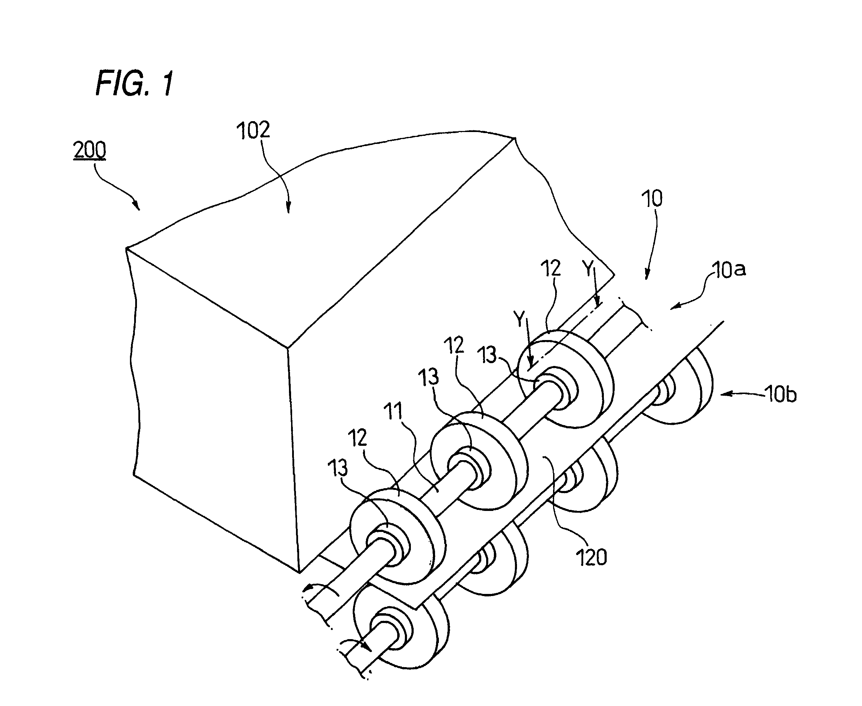

Preferred embodiments of the present invention will now be described with reference to Figs. 1 to 10. Elements which have been described are given the same or corresponding reference numerals to simplify or omit description of the elements.

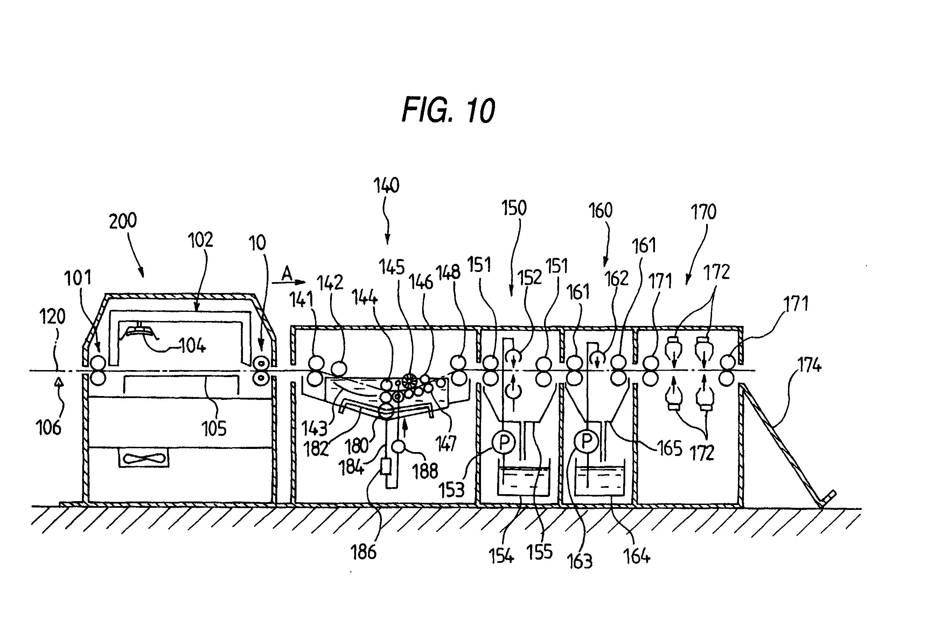

Fig. 10 is a schematic cross sectional view showing a plate making apparatus to which a heating apparatus according to the present invention is applied. The heating apparatus 200 incorporates an introducing roller 101 which is the upstream conveying roller, a heating portion 102 and a downstream conveying roller unit 10 which is the downstream conveying roller.

When a heating process is performed, a printing plate 120 is inserted into an introducing opening formed in the heating apparatus 200. Thus, an introduction detecting sensor 106 detects the printing plate 120 to operate the heater 104. The printing plate 120 introduced into the heating apparatus 200 by an introducing roller 101 composed of a pair of cylindrical rollers is conveyed in a direction indicated with an arrow A in a state in which the printing plate 120 is placed on a guide member 105. Then, the printing plate 120 is subjected to heat treatment in the heating portion 102, followed by discharging the printing plate 120 to the outside of the apparatus by the downstream conveying roller unit 10.

The structure and the like of the downstream conveying roller unit 10 will be described later.

The heated printing plate 120 is conveyed to a developing portion 140 which is a next portion. In the developing portion 140, the printing plate 120 is introduced into developer (for example, developer DP-4 for PS plate manufactured by Fuji Photo Film Co., Ltd.) by the conveying roller 141 and the guide roller 142. Then, the printing plate 120 is moved in the developer along a guide plate 143. Then, the printing plate 120 is held by conveying rollers 144 so as to be guided in such a manner that the developed surface of the printing plate 120 is made contact with a brush roller 145 which is forwards rotated with respect to the direction of the movement. Then, the printing plate 120 is guided to a position above the level of the developer by guide rollers 146 and 147, and then the printing plate 120 is held by a pair of squeeze rollers 148. Thus, the printing plate 120 is conveyed to a water cleaning portion 150.

The developing portion 140 is provided with a heater 180 and a cooling-water pipe 182. Thus, the developer is headed/cooled so that the temperature of the developer is adjusted to a proper level. The developing portion 140 is arbitrarily be supplied with a replenisher by a replenishing pump. An excess portion of the replenisher is allowed to overflow so as to be discharged. The water replenishing pump replenishes water for the purpose of replenishing evaporated water. Moreover, the developing portion 140 incorporates a circulating system composed of a pipe 184, a filter 186 for removing contamination of the developer and a pump 188.

In the water cleaning portion 150, the printing plate 120 is conveyed by the conveying rollers 151, and then spray nozzles 152 spray cleaning water to the printing plate 120. The conveying rollers 151 incorporate pairs of upper and lower rollers disposed across the spray nozzle 152 in the upstream position and a downstream position in the direction A which is the conveying direction, the conveying rollers 151 being disposed to sandwich the printing plate 120. When the conveying rollers 151 are rotated in a state in which the conveying rollers 151 sandwich the printing plate 120, the conveying rollers 151 convey the printing plate 120. The spray nozzles 152 are disposed opposite to each other to face the two sides of the printing plate 120. Cleaning water pumped up from a water receiving tank 154 by a circulation pump 153 is sprayed to the two surfaces of the printing plate 120. Sprayed cleaning water falls from the printing plate 120 so as to be recovered in the water receiving tank 154 through a receiving tray 155.

In a gum solution applying portion 160, the printing plate 120 is conveyed by the conveying rollers 161 so as to be applied with gum solution from a spray nozzle 162.

Pairs of the conveying rollers 161 are disposed at upstream and downstream positions such that the spray nozzles 162 are sandwiched, the conveying rollers 161 being disposed to sandwich the printing plate 120. When the conveying rollers 161 sandwiching the printing plate 120 are rotated, the conveying rollers 161 convey the printing plate 120 in the conveying direction A. The spray nozzle 162 is disposed opposite to an image forming layer of the printing plate 120 to spray gum solution (for example, gum solution GU-7 for a PS plate manufactured by Fuji Photo Film) pumped up from a gum-solution tank 164 by a circulation pump 163 to the image forming layer of the printing plate 120. The sprayed gum solution falls from the printing plate 120 so as to be recovered in a gum-solution tank 164 through a receiving tray 165.

In a drying portion 170, the printing plate 120 is conveyed by conveying rollers 171 so as to be dried by dryers 172.

Pairs of conveying rollers 171 are disposed at upstream and downstream positions such that the dryers 172 are sandwiched, the conveying rollers 171 being disposed to sandwich the printing plate 120. When the conveying rollers 171 sandwiching the printing plate 120 are rotated, the conveying rollers 171 convey the printing plate 120 in the conveying direction A. Two pairs of the dryers 172 are disposed to face the two sides of the printing plate 120 to blow hot air on the two sides of the printing plate 120. Thus, the printing plate 120 subjected to the gum process is dried.

A sequential flow of the process of the printing plate 120 will now be described. Initially, an exposing apparatus (not shown) performs an exposing process using an infrared-ray laser or the like to make an exposed printing plate. Then, as shown in Fig. 10, the printing plate 120 is continuously conveyed from the heating portion 102 to the drying portion 170 through the developing portion 140, the water cleaning portion 150 and the gum solution applying portion 160. In each of the portions, the printing plate 120 is sequentially subjected to predetermined processes.

That is, the printing plate 120 subjected to the Heat treatment is subjected to an elution process in the developing portion 140. Thus, non-hardened portions of an image formation accelerating layer, a photosensitive layer and a hardening layer, that is, non-image regions of the image forming layer except for the hardened portion of the hardening layer are eluted. The printing plate 120 is cleaned with water in the water cleaning portion 150 so that the eluate is removed. Then, the printing plate 120 is subjected to the gum process in the gum solution applying portion 160. Then, the gum solution allowed to adhere to the surface of the printing plate 120 is dried by the drying portion 170. The dried printing plate 120 is conveyed to a tray 174 so as to be accumulated.

Fig. 1 shows the downstream conveying roller unit of the heating apparatus 200 according to the first embodiment of the present invention. Each of a pair of rollers 10a and 10b constituting the downstream conveying roller unit 10 incorporates a cylindrical drive shaft 11. A plurality of disc-like members made of rubber are joined to the drive shaft 11 at positions apart from one another for a predetermined distance in the axial direction. Each of the disc-like members 12 has two sides sandwiched by holding members 13 serving as frictional members. Thus, movement of each of the disc-like members 12 in the axial direction of the drive shaft 11 is limited. The material of the holding member 13 may be metal, resin or the like.

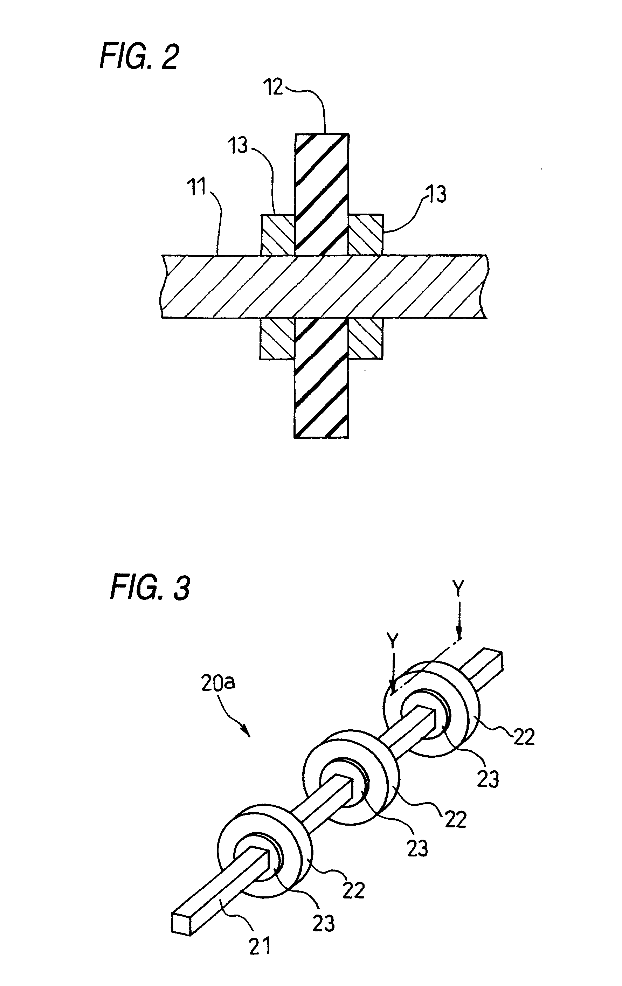

Fig. 2 is a cross sectional view taken along line Y-Y shown in Fig. 1. The disc-like members 12 are rotatively joined to the drive shaft 11. The two side surfaces of the disc-like members 12 are sandwiched by the holding members 13 secured to the drive shaft 11 and applied with a predetermined pressure. Therefore, the disc-like members 12 are, in a usual state, rotated integrally with the drive shaft 11 to convey the printing plate. If additional external force is exerted on the disc-like members 12, slip occurring between contact surfaces of the disc-like members 12 and the holding members 13 causes the disc-like members 12 to relatively rotate with respect to the drive shaft.

The operation of this embodiment will now be described. As shown in Fig. 1, the printing plate 120 subjected to the heat treatment in the heating portion 102 is guided to the downstream conveying rollers 10 by a guide portion (not shown) in the heating portion. The guide member 105 may be constituted by wires which are made line-contact with the printing plate. At this time, the temperature of the surface of the printing plate has been raised to about 100°C. Therefore, the printing plate 120 expands in the lengthwise so that stress is sometimes produced in the printing plate. In the foregoing case, the stress produced in the printing plate 120 causes the disc-like members 12 of the downstream conveying rollers to be rotated faster than the rotating drive shaft 11.

The heating apparatus 200 having the above-mentioned structure is able to prevent deformation of a portion of the printing plate due to the expansion of the printing plate 120 in the lengthwise direction to rise over the guide members. Therefore, the printing plate can be subjected to the heat treatment without formation of a line or the like on the surface of the printing plate 120.

Fig. 3 shows either group of rollers constituting the downstream conveying rollers according to a second embodiment of the present invention. In the following embodiments, the structures except for the downstream conveying rollers are the same as those of the first embodiment.

A roller 20a shown in Fig. 3 incorporates a drive shaft 21 in the form of a square pole. A plurality of disc-like members 22 made of rubber are joined to the drive shaft 21 at positions apart from one another for a predetermined distance in the axial direction. Moreover, stoppers 23 are secured to the drive shaft 21 at positions apart from the two side surfaces of the disc-like members 22 for a predetermined distance. The material of the stopper 23 may be metal, resin or the like. Each of the disc-like members 22 has a central hole having a shape corresponding to the cross sectional shape of the drive shaft 21 at the position at which each of the disc-like members 22 is joined to the drive shaft 21. Since the drive shaft 21 is inserted into the central holes, the disc-like members 22 can be engaged to the drive shaft.

The drive shaft 21 is not limited to the square pole. The drive shaft 21 may be a polygonal pole. Any shape may be employed if the shape permits engagement to the central holes of the disc-like members 22.

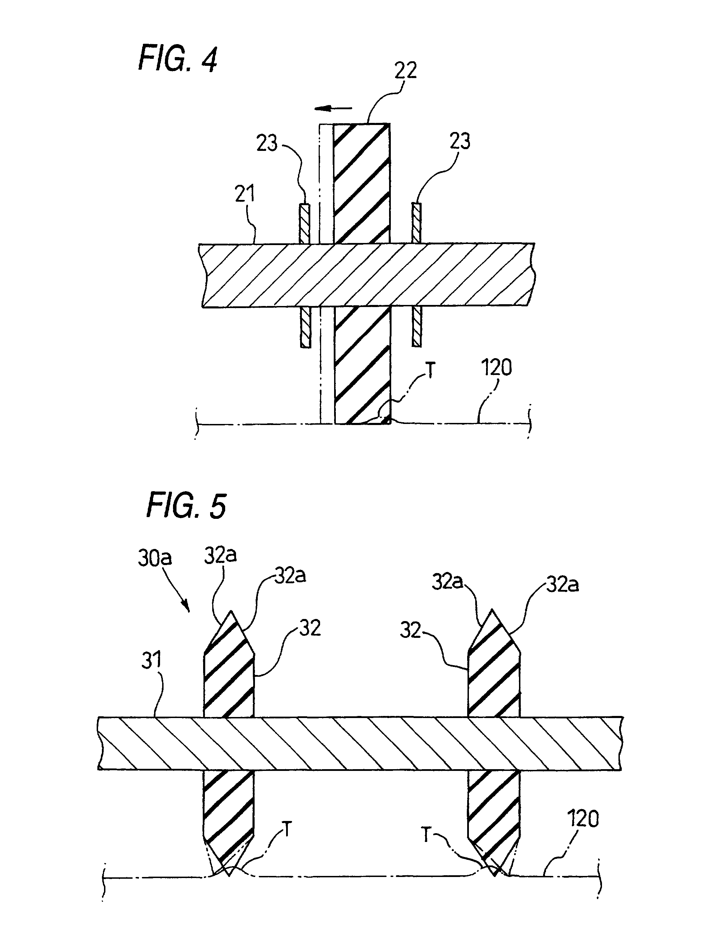

Fig. 4 is a cross sectional view taken along line Y-Y shown in Fig. 3. The disc-like member 22 is joined movably in the axial direction of the drive shaft 21.

The stoppers 23 are secured to the drive shaft 21 at positions on the two sides of each of the disc-like members 22 such that the stoppers 23 are positioned apart from the disc-like members 22 at predetermined distances. Therefore, the amount of movement of the disc-like member 22 in the axial direction is limited by the stoppers 23.

The operation of this embodiment will now be described. The disc-like members 22 are rotated when the drive shaft 21 is rotated to discharge the printing plate 120 from the heating apparatus. If portion T of the printing plate 120, deformed to rise over the guide member as shown in Fig. 12, is moved to a space between the pair of the rollers of the downstream conveying rollers, the disc-like members 22 are moved in the axial direction of the drive shaft 21 to correspond to the shape of the deformed portion T as indicated with an alternate long and two short dashes line shown in Fig. 4. Thus, the deformed portion which has allowed to rise as described above is not crushed during the passage.

Fig. 5 is a cross sectional view showing either of rollers constituting the downstream conveying rollers according to a third embodiment of the present invention. As shown in Fig. 5, a roller 30a has a structure that a plurality of disc-like members 32 are joined to the drive shaft 31 at positions apart from one another for predetermined distances in the axial direction of the drive shaft 31.

The disc-like members 32 have central holes having shapes corresponding to the cross sectional shapes of the drive shaft 31 at positions at which the disc-like members 32 are joined to the drive shaft 31. When the drive shaft is inserted into the central holes, the disc-like members 32 can be engaged to the drive shaft.

The disc-like members 32 have form-variable portions at the peripheries, the form-variable portions being tapered surfaces 32a which reduce the thickness of each of the disc-like members 32 toward the periphery. In this embodiment, the tapered surfaces 32a having the same angles of inclination are provided for the two side surfaces of the disc-like members 32. If the form-variable portions can facilitate adequate deformation of the disc-like members in the direction of the thickness of each of the disc-like members, another structure instead of the tapered surfaces may be employed. For example, recesses or holes (not shown) may be provided in the disc-like members. The form-variable portion may be formed in portions except for the periphery of the disc-like member.

The operation of this embodiment will now be described. The disc-like members 32 are rotated when the drive shaft 31 is rotated to discharge the printing plate 120 from the heating apparatus. When portions T of the printing plate deformed to rise over the guide member have been conveyed to a portion between the pair of the rollers of the downstream conveying rollers, the form-variable portions of the disc-like members 32 are deformed in the direction of the thicknesses of the disc-like members 32 to correspond to the shapes of the deformed portions T, as indicated with alternate long and two short dashes lines shown in Fig. 5. Thus, the deformed portions T which have been allowed to rise as described above are not crushed during passage.

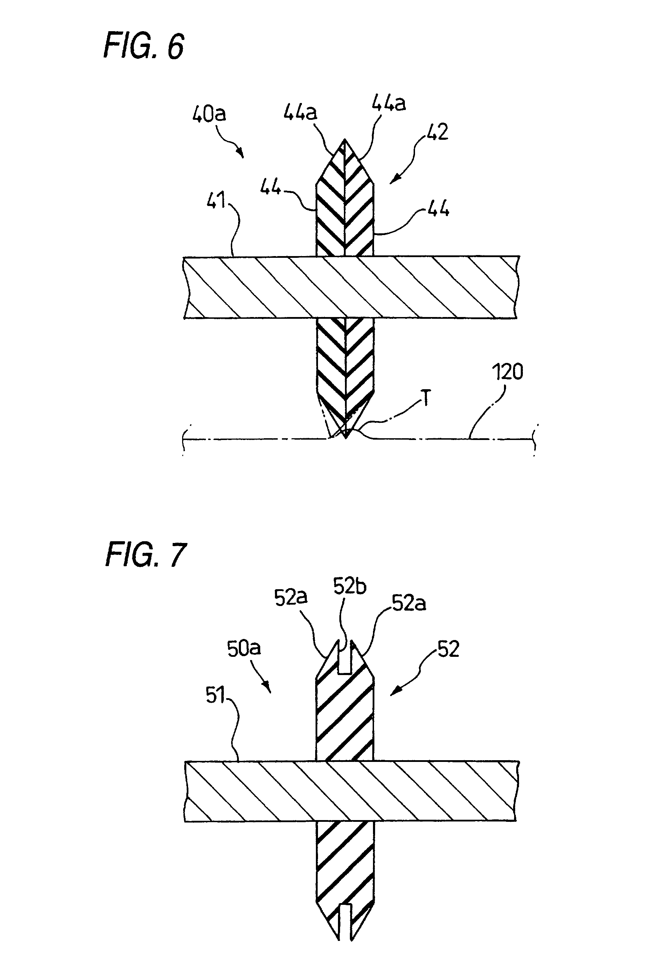

Fig. 6 is a partial cross sectional view showing either of rollers which constitute the downstream conveying rollers according to a fourth embodiment of the present invention. A roller 40a has a structure (not shown) that a plurality of disc-like members 42 are joined to a drive shaft 41 at positions apart from one another for predetermined distances in the axial direction of the drive shaft 41.

Each of the disc-like members 42 has a structure constituted by stacking two thin disc-like members 44. Each of the thin disc-like members 44 has a central hole formed into a shape corresponding to the cross sectional shape of the drive shaft 41 at each position at which the thin disc-like member 44 is joined to the drive shaft 41.

Each of the thin disc-like members 44 has a tapered surface 44a which reduces the thickness of the thin disc-like member 44 toward the periphery of the thin disc-like member 44. The tapered surface 44a is formed on only either side surface of each of the thin disc-like members 44 in such a manner that when the two thin disc-like members 44 have been laminated, the sides opposite to the contact surfaces are made to be the tapered surfaces 44a.

The operation of this embodiment will now be described. The disc-like members 42 are rotated when the drive shaft 41 is rotated. Thus, the disc-like members 42 discharge the printing plate 120 from the heating apparatus. If portion T of the printing plate deformed to rise over the guide member has been conveyed to a space between the pair of the rollers of the downstream conveying rollers, the form-variable portions constituted by the tapered surfaces of the thin disc-like members 44 are deformed in the direction of the disc-like members 42 to correspond to the shape of the deformed portion T of the printing plate, as indicated with an alternate long and two dashes line. Thus, the deformed portion T of the printing plate is not crushed and passage is permitted.

Although the two thin disc-like members 44 may be bonded to each other, a disc-like member formed by stacking the two members in place of bonding furthermore facilitates deformation of the form-variable portions.

Fig. 7 is a partial cross sectional view showing either of rollers constituting the downstream conveying rollers according to a fifth embodiment of the present invention. A roller 50a has a structure (not shown) that a plurality of disc-like members 52 are joined to a drive shaft 51 at position apart from one another for a predetermined distance in the axial of the drive shaft 51.

Each of the disc-like members 52 has a central hole formed into a shape corresponding to the cross sectional shape of the drive shaft 51 at the position at which each of the disc-like members 52 is joined to the drive shaft 51. Since the drive shaft 51 is inserted into the central hole, the disc-like members 52 can be engaged to the drive shaft 51.

Each of the disc-like members 52 has form-variable portions formed in the periphery thereof, the form-variable portions being tapered surfaces 52a which reduce the thickness of each of the disc-like members 52. In this embodiment, the tapered surfaces 52a having the same angle of inclination are formed on the two side surfaces of the disc-like members 52. Moreover, each of the disc-like members 52 has an outer end surface that extends perpendicular to the side surfaces of the disc like member 52, A recess 52b is formed at the outer end surface of each of the disc-like members 52.

Also the above-mentioned structure attains a similar effect and a similar operation to those obtainable from the third and fourth embodiments.

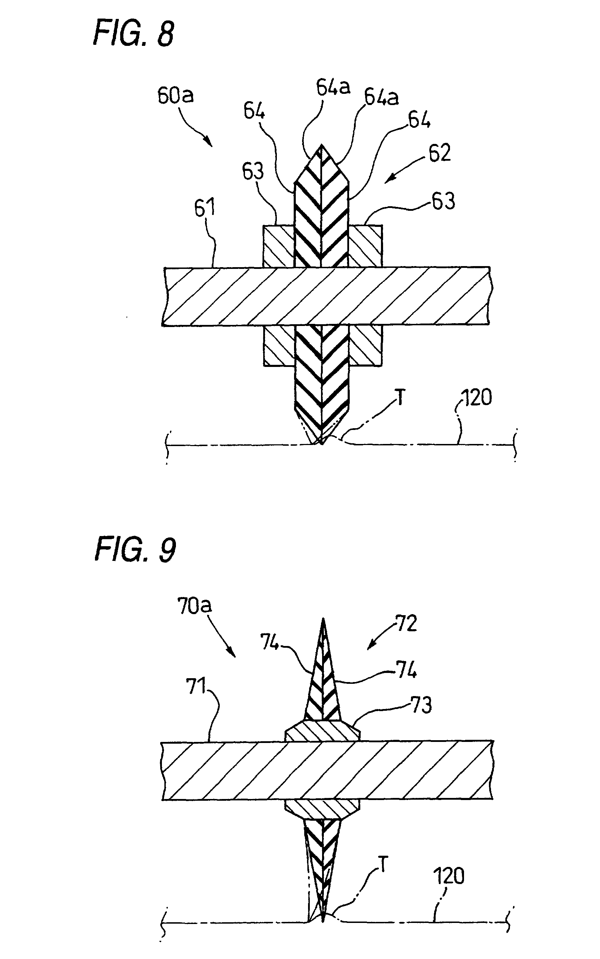

Fig. 8 is a partial cross sectional view showing either of rollers constituting the downstream conveying rollers according to a sixth embodiment of the present invention. This embodiment has a structure that the structures of the first embodiment and the fourth embodiment are combined with each other. This embodiment has a structure (not shown in Fig. 8) that a plurality of disc-like members 62 are joined to a drive shaft 61 at positions apart from one another for a predetermined distance in the axial direction of the drive shaft 61. Note that the drive shaft 61 is formed into a cylindrical shape. Each of the disc-like members 62 is constituted by bringing two thin disc-like members 64 into contact with each other. Each of the thin disc-like members 64 has a tapered surface 64a which is formed at the periphery thereof and which reduces the thickness of each of the thin disc-like members 64 toward the periphery of each of the thin disc-like members 64.

The disc-like members 62 are rotatively joined to the drive shaft 61. The two side surfaces of each of the disc-like members 62 are sandwiched by holding member A 63 secured to the drive shaft 61 so that a predetermined pressure is applied to the foregoing two side surfaces. Therefore, the disc-like members 62 are, in a usual state, integrally rotated with the drive shaft 61 to convey the printing plate.

If the printing plate is heated and stress which causes the printing plate to expand in the lengthwise direction of the printing plate is produced in the printing plate, the stress causes the disc-like members 62 to be rotated faster than the drive shaft 61 due to slip occurring between contact surfaces of each of the disc-like members 62 and each of the holding members 63. At this time, the periphery which is the form-variable portion of each of the disc-like members 62 is deformed in the direction of the thickness of each of the disc-like members 62 to correspond to the shape of the deformed portion T which is formed due to expansion of the printing plate 120 in the widthwise direction of the printing plate 120. Thus, the deformed portion T of the printing plate is not crushed and passage is permitted.

The foregoing structure is able to furthermore effectively prevent formation of a line or the like on the surface of the printing plate.

Fig. 9 is a partial cross sectional view showing either of rollers constituting the downstream conveying rollers according to a seventh embodiment of the present invention. A roller 70a has a structure (not shown) that a plurality of disc-like members 72 are joined to a drive shaft 51 at positions apart from one another for a predetermined distance.

Each of the disc-like members 72 has a structure constituted by bringing two thin disc-like members 74 into contact with each other. The side surfaces of each of the thin disc-like members 74 are tapered to reduce the thickness of each of the thin disc-like members 74 toward the periphery of each of the thin disc-like members 74.

Each of the thin disc-like members 74 has a central hole into which a bearing 73 is joined. The bearing 73 has an outer shape which can be engaged to the central hole of each of the thin disc-like members. The bearings 73 are secured to the drive shaft 71. The material of the bearing 73 may be metal, resin or hard rubber.

The above-mentioned structure in which the thickness of each of the disc-like members 72 is very small enables the printing plate 120 to reliably be conveyed in a usual state. If the disc-like member 72 approaches the deformed portion T of the printing plate, the periphery of the disc-like member is deformed in the direction of the thickness of the disc-like member. Thus, the deformed portion T of the printing plate is not crushed and passage is permitted.

As described above, the heating apparatus according to the present invention is able to perform an ideal heating process of a printing plate without formation of a line or the like on the surface of the printing plate.

## Claims

1. A heating apparatus (200) comprising: a heating portion (102) for conveying a printing plate (120) incorporating a metal support plate, on which a photosensitive layer is formed, into a hot atmosphere radiated from a heat source (104) ; upstream conveying rollers (101) and downstream conveying rollers (110) which are disposed upstream and downstream of said heating portion and which are structured to hold said support member from upper positions and lower positions to convey said support member,
**characterized in that**
at least one of said rollers which constitute said downstream conveying rollers has a drive shaft (11) and a central hole through which said drive shaft is inserted, and a plurality of disc-like members (12) rotatively joined to said drive shaft and friction members (13) for exerting frictional resistance on said disc-like members when said disc-like members are rotated with respect to said drive shaft, are provided.

2. A heating apparatus according to claim 1, wherein said disc-like members are elastically deformable in a direction of the thickness thereof, wherein said thickness is in the axial direction of said drive shaft.

3. A heating apparatus comprising: a heating portion for conveying a printing plate incorporating a metal support plate, on which a photosensitive layer is formed, into a hot atmosphere radiated from a heat source; upstream conveying rollers and downstream conveying rollers which are disposed upstream and downstream of said heating portion and which are structured to hold said support member from upper positions and lower positions to convey said support member,
**characterized in that**
at least one of said rollers which constitute said downstream conveying rollers, has a drive shaft (21) and a central hole through which said drive shaft is inserted, and a plurality of disc-like members (22) joined to said drive shaft movably in an axial direction of said drive shaft and being driveable rotationally with said drive shaft, and stopper members (23) for limiting the quantity of movement of said disc-like members in the axial direction to a predetermined range are provided.

4. A heating apparatus comprising: a heating portion for conveying a printing plate incorporating a metal support plate, on which a photosensitive layer is formed, into a hot atmosphere radiated from a heat source; upstream conveying rollers and downstream conveying rollers which are disposed upstream and downstream of said heating portion and which are structured to hold said support member from upper positions and lower positions to convey said support member,
**characterized in that**:
at least one of said rollers which constitute said downstream conveying rollers, has a drive shaft (31) and a central hole through which said drive shaft is inserted, and
a plurality of disc-like members (32) joined to said drive shaft are provided, said disc-like members being elastically deformable in a direction of the thickness of said disc-like member, wherein said thickness is in the axial direction of said drive shaft.

5. The heating apparatus according to claim 4, wherein said disc-like members (72) have a structure constituted by bringing two thin disc-like member (74) into contact with each other, each of the thin, disc-like member (74) have a central hole into which a bearing (73) is joined. Said bearings having an outer shape which can be engaged to the central hole of said thin disc-like members (74). Said bearing being secured to said drive shaft (71).

## Patentansprüche

1. Heizvorrichtung (200) mit: einem Heizbereich (102) zum Befördern einer Druckplatte (120), die durch eine Metallstützplatte gebildet wird, auf welcher sich eine fotosensitive Schicht befindet, in eine von einer Wärmequelle (104) ausgestrahlte heiße Atmosphäre; und stromaufwärtigen Förderwalzen (101) und stromabwärtigen Förderwalzen (110), die stromaufwärts bzw. stromabwärts des Heizbereichs angeordnet sind und so aufgebaut sind, dass sie das Stützelement an oberen und unteren Positionen halten, um das Stützelement zu befördern,
**dadurch gekennzeichnet, dass**
zumindest eine der Walzen, die die stromabwärtigen Förderwalzen bilden, eine Antriebswelle (11) und eine mittlere Öffnung hat, durch welche hindurch die Antriebswelle eingesetzt ist, und mehrere scheibenartige Elemente (12) vorgesehen sind, die drehbar mit der Antriebswelle verbunden sind, sowie Reibelemente (13) zum Ausüben eines Reibwiderstands auf die scheibenartigen Elemente, wenn die scheibenartigen Elemente bezüglich der Antriebswelle gedreht werden.

2. Heizvorrichtung nach Anspruch 1, wobei die scheibenartigen Elemente elastisch in Richtung ihrer Dicke verformbar sind, wobei die Dicke sich in axialer Richtung der Antriebswelle erstreckt.

3. Heizvorrichtung mit: einem Heizbereich zum Befördern einer Druckplatte, die durch eine Metallstützplatte gebildet wird, auf welcher eine fotosensitive Schicht ausgeformt ist, in eine von einer Hitzequelle ausgestrahlte heiße Atmosphäre; und stromaufwärtigen Förderwalzen und stromabwärtigen Förderwalzen, die stromaufwärts bzw. stromabwärts des Heizbereichs angeordnet sind und so aufgebaut sind, dass sie das Stützelement an oberen und unteren Positionen halten, um das Stützelement zu befördern,
**dadurch gekennzeichnet, dass**
zumindest eine der Walzen, die die stromabwärtigen Förderwalzen bilden, eine Antriebswelle (21) und eine mittlere Öffnung hat, durch welche hindurch sich die Antriebswelle erstreckt, und dass mehrere scheibenartige Elemente (22), die mit der Antriebswelle beweglich in axialer Richtung der Antriebswelle verbunden sind und mit der Antriebswelle drehend antreibbar sind, und Anschlagelemente (23) zum Begrenzen des Betrags der Bewegung der scheibenartigen Elemente in axialer Richtung auf einen vorbestimmten Bereich vorgesehen sind.

4. Heizvorrichtung mit: einem Heizbereich zum Befördern einer Druckplatte, die durch eine Metallstützplatte gebildet wird, auf welcher eine fotosensitive Schicht ausgeformt ist, in eine von einer Hitzequelle ausgestrahlte heiße Atmosphäre; und stromaufwärtigen Förderwalzen und stromabwärtigen Förderwalzen, die stromaufwärts bzw. stromabwärts des Heizbereichs angeordnet sind und so aufgebaut sind, dass sie das Stützelement an oberen und unteren Positionen halten, um das Stützelement zu befördern,
**dadurch gekennzeichnet, dass**
zumindest eine der Walzen, die die stromabwärtigen Förderwalzen bilden, eine Antriebswelle (31) und eine mittlere Öffnung hat, durch welche hindurch sich die Antriebswelle erstreckt, und mehrere scheibenartige Elemente (32) vorgesehen sind, die mit der Antriebswelle verbunden sind, wobei diese scheibenartigen Elemente in einer Richtung ihrer Dicke elastisch verformbar sind, welche Dicke sich in axialer Richtung der Antriebswelle erstreckt.

5. Heizvorrichtung nach Anspruch 4, wobei die scheibenartigen Elemente (72) einen Aufbau haben, der gebildet wird, indem zwei dünne scheibenartige Elemente (74) in Kontakt miteinander gebracht werden, wobei jedes der dünnen scheibenartigen Elemente (74) eine mittlere Öffnung hat, in welche ein Lager (73) eingefügt ist, welche Lager eine äußere Gestalt haben, die mit der mittleren Öffnung der dünnen scheibenartigen Elemente (74) in Eingriff bringbar ist, wobei die Lager an der Antriebswelle (71) angebracht sind.

## Revendications

1. Appareil de chauffage (200) comprenant : une partie de chauffage (102) pour transporter une plaque d'impression (120) incorporant une plaque métallique de support, sur laquelle une couche photosensible est formée, dans une atmosphère chaude émanant d'une source de chaleur (104) ; des rouleaux de transport amont (101) et des rouleaux de transport aval (110) qui sont disposés en amont et en aval de ladite partie de chauffage et qui sont structurés pour maintenir ledit élément de support à partir de positions supérieures et de positions inférieures afin de transporter ledit élément de support,
**caractérisé en ce que**
au moins un desdits rouleaux qui constituent lesdits rouleaux de transport aval a un arbre d'entraînement (11) et un trou central à travers lequel ledit arbre d'entraînement est inséré, et une pluralité d'éléments (12) semblables à des disques, raccordés de manière rotative audit arbre d'entraînement et des éléments de friction (13) pour exercer une résistance de friction sur lesdits éléments semblables à des disques lorsque lesdits éléments semblables à des disques sont tournés par rapport audit arbre d'entraînement, sont prévus.

2. Appareil de chauffage selon la revendication 1, dans lequel lesdits éléments semblables à des disques sont déformables de manière élastique dans la direction de leur épaisseur, et dans lequel ladite épaisseur est dans la direction axialle dudit arbre d'entraînement.

3. Appareil de chauffage comprenant : une partie de chauffage pour transporter une plaque d'impression incorporant une plaque métallique de support, sur laquelle une couche photosensible est formée, dans une atmosphère chaude émanant d'une source de chaleur ; des rouleaux de transport amont et des rouleaux de transport aval qui sont disposés en amont et en aval de ladite partie de chauffage et qui sont structurés pour maintenir ledit élément de support à partir de positions supérieures et inférieures afin de transporter ledit élément de support,
**caractérisé en ce que**
au moins un desdits rouleaux qui constituent lesdits rouleaux de transport aval a un arbre d'entraînement (21) et un trou central à travers lequel ledit arbre d'entraînement est inséré, et une pluralité d'éléments semblables à des disques (22) raccordées audit arbre d'entraînement de manière mobile dans la direction axialle dudit arbre d'entraînement et pouvant être entraînés de manière rotative avec ledit arbre d'entraînement, et des éléments de butée (23) pour limiter à une plage prédéterminée la quantité de déplacement desdits éléments semblables à des disques dans la direction axialle, sont prévus.

4. Appareil de chauffage comprenant : une partie de chauffage pour transporter une plaque d'impression incorporant une plaque métallique de support, sur laquelle une couche photosensible est formée, dans une atmosphère chaude émanant d'une source de chaleur ; des rouleaux de transport amont et des rouleaux de transport aval qui sont disposés en amont et en aval de ladite partie de chauffage et qui sont structurés pour maintenir ledit élément de support à partir de positions supérieures et de positions inférieures afin de transporter ledit élément de support,
**caractérisé en ce que** :
au moins un desdits rouleaux qui constituent lesdits rouleaux de transport aval a un arbre d'entraînement (31) et un trou central à travers lequel ledit arbre d'entraînement est inséré, et
une pluralité d'éléments semblables à des disques (32) raccordés audit arbre d'entraînement sont prévus, lesdits éléments semblables à des disques étant déformables de manière élastique dans la direction de l'épaisseur desdits éléments semblables à des disques, et dans lesquels ladite épaisseur est dans la direction axialle dudit arbre d'entraînement.

5. Appareil de chauffage selon la revendication 4, dans lequel lesdits éléments semblables à des disques (72) ont une structure constituée de deux éléments fins (74) semblables à des disques mis en contact l'un avec l'autre, chacun des éléments fins (74) semblables à des disques a un trou central à travers lequel un palier (73) est raccordé ; lesdits paliers ayant une forme extérieure qui peut être mise en prise dans le trou central desdits éléments fins (74) semblables à des disques ; ledit palier étant fixé audit arbre d'entraînement (71).
